(19) Europäisches Patentamt
European Patent Office
Office européen des brevets

(11) EP 3 276 533 A2

(12) DEMANDE DE BREVET EUROPEEN

(43) Date de publication:
31.01.2018 Bulletin 2018/05

(51) Int Cl.:
G06K 9/00 (2006.01)

(21) Numéro de dépôt: 17183876.6

(22) Date de dépôt: 28.07.2017

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR
Etats d'extension désignés:
BA ME
Etats de validation désignés:
MA MD

(30) Priorité: 29.07.2016 FR 1657389

(71) Demandeurs:
• Commissariat à l'énergie atomique
et aux énergies alternatives
75015 Paris (FR)

• Safran Identity & Security
92130 Issy-les-Moulineaux (FR)

(72) Inventeurs:
• MAINGUET, Jean-François
38100 Grenoble (FR)
• FOURRE, Joël Yann
78160 Marly le Roi (FR)

(74) Mandataire: Brevalex
95, rue d'Amsterdam
75378 Paris Cedex 8 (FR)

(54) **CAPTEUR DE MOTIF THERMIQUE A ELEMENTS CHAUFFANTS MUTUALISES**

(57) Capteur (100) de motif thermique comportant une matrice de plusieurs lignes et colonnes de pixels (102), chaque pixel comprenant au moins une capacité pyroélectrique formée par au moins une portion de matériau pyroélectrique (106) disposée entre une électrode inférieure (108) et une électrode supérieure (110), dans lequel une première des électrodes inférieure et supérieure forme une électrode de lecture du pixel, et comportant en outre une pluralité de portions électriquement conductrices (111) chacune apte à chauffer par effet Joule, indépendamment des autres portions électriquement conductrices, les portions de matériau pyroélectrique des capacités pyroélectriques des pixels d'au moins deux lignes de pixels adjacentes associées à la portion électriquement conductrice, et disposée en regard d'au moins une partie de la surface des électrodes de lecture de chacun des pixels des lignes associées à la portion électriquement conductrice.

FIG.2

EP 3 276 533 A2

**Description**

## DOMAINE TECHNIQUE ET ART ANTÉRIEUR

L'invention se rapporte à un capteur de motif thermique dans lequel les éléments chauffants sont mutualisés pour que chacun des éléments chauffants soit apte à chauffer plusieurs lignes de pixels. Ce capteur de motif thermique correspond avantageusement à un capteur d'empreinte digitale par détection thermique.

Un capteur d'empreintes digitales comporte des moyens de détection thermique. Ces moyens de détection thermique peuvent correspondre à des éléments pyroélectriques, des diodes, des thermistances ou tout autre élément sensible à la température et permettant de convertir une variation de température en une variation de potentiel ou de courant électrique.

La détection d'une empreinte digitale peut être réalisée par des capteurs dits « passifs » exploitant une différence de températures entre le doigt et le capteur, comme décrit dans les documents US 4 394 773, US 4 429 413 et US 6 289 114. Ces capteurs ont toutefois pour inconvénient de réaliser une mesure qui dépend uniquement de la différence de températures entre le doigt et le capteur. Il peut donc arriver que le niveau du signal obtenu soit nul lorsque le doigt et le capteur sont à la même température (par exemple lorsque le doigt reste un certain temps sur le capteur), ou que le contraste des images capturées varie et pose alors des problèmes lors du traitement ultérieur des images.

Pour éliminer les problèmes soulevés par les capteurs thermiques passifs, notamment dans le cas d'une acquisition statique où le doigt ne bouge pas, des capteurs d'empreintes dits « actifs » ont été proposés, comme par exemple ceux décrits dans les documents US 6 091 837 et EP 2 385 486 A1. Dans un tel capteur, chaque pixel comporte une capacité pyroélectrique formée de deux électrodes conductrices entre lesquelles une portion de matériau pyroélectrique est disposée, et un élément chauffant. Cet élément chauffant dissipe une certaine quantité de chaleur dans le pixel, et l'échauffement du pixel est mesuré au bout d'un certain temps d'acquisition, appelé temps d'intégration, en présence du doigt sur le capteur. Cela permet de distinguer, au niveau de chaque pixel, la présence d'une crête ou d'une vallée de l'empreinte détectée suivant que la chaleur est absorbée par la peau (pixel en présence d'une crête de l'empreinte) ou conservée dans le pixel (pixel en présence d'une vallée de l'empreinte). Cela conduit à une température finale plus faible dans le cas d'un pixel en présence d'une crête, où la chaleur est absorbée par la peau, par rapport à un pixel en présence d'une vallée.

Au premier ordre, un tel capteur permet de mesurer la capacité calorifique, également appelée chaleur massique ou capacité thermique massique, d'un élément en contact avec le capteur. Les mesures obtenues dépendent également de la conductivité thermique entre le capteur et la partie de l'élément (crête ou vallée dans le cas d'une empreinte digitale) en présence.

Pour former un capteur thermique actif, les pixels de ce capteur sont couplés à des éléments chauffants utilisant généralement l'effet Joule qui dissipent de la chaleur depuis un élément résistif qui est parcouru par un courant. Un des niveaux de l'empilement technologique formant les pixels est avantageusement utilisé pour former ces éléments chauffants. Par exemple, il est possible d'utiliser un des niveaux électriquement conducteurs servant à réaliser les transistors et les interconnexions du capteur si l'un de ces niveaux comporte un matériau conducteur présentant une résistivité adéquate et sur lequel il suffit d'appliquer une des tensions déjà disponibles, par exemple la tension d'alimentation du capteur, pour générer un chauffage par effet Joule. Cela est notamment utilisé lorsque le capteur comporte des transistors de type TFT (« Thin-Film Transistor », ou transistor en couches minces) réalisés sur un substrat de verre ou de plastique.

Les pixels d'un tel capteur sont disposés en formant une matrice de plusieurs lignes et de plusieurs colonnes. La lecture des pixels est généralement réalisée ligne par ligne. Les éléments chauffants peuvent alors être également commandés par ligne à l'aide d'un transistor se trouvant en tête de chaque ligne, évitant ainsi l'ajout de transistors de commande dans chacun des pixels. Chaque ligne d'éléments chauffants est par exemple connectée, d'un côté de la matrice de pixels, à la masse, et de l'autre coté au transistor de commande associé à la ligne de pixels et relié à une alimentation adaptée de manière à maîtriser le courant parcourant les éléments chauffants, et donc la puissance thermique injectée par effet Joule dans les pixels par ces éléments chauffants.

Pour réaliser une lecture de la variation du nombre de charges électriques apparaissant dans les capacités pyroélectriques des pixels d'une des lignes de pixels du capteur thermique actif, la ligne d'éléments chauffants associée à la ligne de pixels destinée à être lue est activée en faisant circuler un courant de chauffage dans cette ligne d'éléments chauffants. Chacun des pixels comporte au moins un transistor de sélection, et les transistors de sélection des pixels de chaque colonne de pixels sont reliés à une ligne conductrice elle-même reliée à un circuit de lecture. Lors de la lecture d'une ligne de pixels, les transistors de sélection des pixels de cette ligne sont mis à l'état passant, ce qui permet de relier les noeuds actifs des pixels de cette ligne aux circuits de lecture se trouvant en pied de chacune des colonnes de pixels. Les transistors de sélection bloqués des pixels appartenant aux autres lignes de pixels empêchent le déplacement de charges depuis ces autres pixels vers les circuits de lecture. D'autres transistors peuvent également être présents dans chaque pixel, notamment lorsque les pixels sont lus en tension et qu'ils nécessitent la présence d'un transistor de réinitialisation et d'un transistor suiveur de tension, ou que le capteur forme également un capteur optique dans lequel un transistor est présent dans chaque pixel pour relier une photodiode de chaque pixel à un circuit de lecture dédié.

Lorsque le capteur est réalisé avec des transistors de type TFT, les transistors sont réalisés par des techniques de lithographie permettant leur réalisation avec une bonne résolution. Le matériau pyroélectrique est ensuite déposé puis les électrodes supérieures des capacités pyroélectriques sont réalisées. Les éléments chauffants doivent ensuite être réalisés.

Il serait avantageux de pouvoir réaliser les électrodes supérieures et les éléments chauffants, notamment pour capteur réalisé en technologie TFT, par impression (héliogravure, offset gravure, sérigraphie, ...) étant donné le faible coût de mise en oeuvre des techniques d'impression. Toutefois, les résolutions pouvant être atteintes avec ces techniques ne sont pas compatibles avec les résolutions recherchées pour certains capteurs de motif thermique, par exemple pour un capteur d'empreinte digitale comprenant des pixels réalisés avec un pas d'environ 50,8 $\mu$m dans le cas d'un capteur de résolution égale à 500 dpi (« dot per inch »).

## EXPOSÉ DE L'INVENTION

Un but de la présente invention est de proposer un capteur de motif thermique comportant des éléments chauffants compatibles avec une réalisation par impression tout en permettant l'obtention d'une bonne résolution des pixels.

Pour cela, l'invention propose un capteur de motif thermique comportant une matrice de plusieurs lignes et colonnes de pixels, chaque pixel comprenant au moins une capacité pyroélectrique formée par au moins une portion de matériau pyroélectrique disposée entre une électrode inférieure et une électrode supérieure, dans lequel une première des électrodes inférieure et supérieure forme une électrode de lecture du pixel, et comportant en outre une pluralité de portions électriquement conductrices chacune apte à chauffer par effet Joule, indépendamment des autres portions électriquement conductrices, les portions de matériau pyroélectrique des capacités pyroélectriques des pixels d'au moins deux lignes de pixels adjacentes associées à la portion électriquement conductrice, et disposée en regard d'au moins une partie de la surface des électrodes de lecture de chacun des pixels des lignes associées à la portion électriquement conductrice.

Dans ce capteur, chacune des portions électriquement conductrices forme donc l'élément chauffant d'au moins deux lignes de pixels adjacentes. Ainsi, la résolution nécessaire à la réalisation de ces portions électriquement conductrices est divisée d'un facteur au moins égal à deux par rapport à la résolution des pixels.

Dans un tel capteur, les portions électriquement conductrices formant les éléments chauffants peuvent donc être réalisées avec des techniques ne permettant pas d'obtenir une résolution égale à celle des pixels du capteur, par exemple par impression.

L'élément comprenant le motif thermique destiné à être détecté par le capteur est destiné à être en contact physique avec le capteur, c'est-à-dire disposé contre le capteur lors de la détection de ce motif thermique.

Chacune des portions électriquement conductrices peut être disposée en regard de l'ensemble de la surface de l'électrode de lecture de chacun des pixels des lignes associées à la portion électriquement conductrice.

En variante, chacune des portions électriquement conductrices peut être disposée en regard d'une partie de la surface de l'électrode de lecture de chacun des pixels des lignes associées à la portion électriquement conductrice, les surface des électrodes de lecture des pixels se trouvant en regard des portions électriquement conductrices pouvant être sensiblement égales les unes des autres. Ainsi, même si les portions électriquement conductrices formant les éléments chauffants ne recouvrent pas complètement les électrodes de lecture des pixels, un chauffage similaire entre tous les pixels chauffés par une telle portion électriquement conductrice est obtenu grâce au recouvrement identique des électrodes de lecture de ces pixels par la portion électriquement conductrice.

Selon une première réalisation, il est possible que le capteur de motif thermique soit tel que :

- chaque pixel comprend en outre au moins un transistor de sélection relié à l'électrode de lecture dudit pixel,
- pour chaque ligne de pixels, les grilles des transistors de sélection des pixels de ladite ligne de pixels sont reliées à une ligne de sélection de ladite ligne de pixels,
- pour chaque colonne de pixels, les transistors de sélection des pixels de ladite colonne de pixels sont reliés à une colonne de lecture de ladite colonne de pixels qui est reliée à un circuit de lecture commun aux pixels de ladite colonne de pixels.

Dans ce cas, le capteur de motif thermique peut comporter en outre un circuit de commande apte à mettre en oeuvre, pour la lecture d'une ligne de pixels, au moins les étapes suivantes :

- mise à l'état passant des transistors de sélection des pixels de ladite ligne ;
- application d'une tension de chauffage aux extrémités de la portion électriquement conductrice associée à ladite ligne de pixels ;
- réinitialisation des circuits de lecture ;
- attente d'un temps d'intégration correspondant à la mesure du motif thermique par les pixels de ladite ligne ;
- lecture de la quantité de charges électriques reçues par les circuits de lecture ;
- mise à l'état bloqué des transistors de sélection des pixels de ladite ligne.

L'étape de lecture de la quantité de charges électriques reçues par les circuits de lecture peut être suivie d'une étape d'arrêt de l'application de la tension de chauffage aux extrémités de la portion électriquement conductrice associée à ladite ligne de pixels.

De plus, le circuit de commande peut être apte à commander la lecture successive de plusieurs lignes de pixels telle que deux lignes de pixels lues successivement soient associées à des portions électriquement conductrices différentes. Ainsi, il n'est pas nécessaire de respecter un temps de refroidissement entre les deux lignes de pixels lues successivement du fait que la deuxième ligne de pixels lue n'est pas chauffée par la même portion électriquement conductrice que celle chauffant la ligne de pixels lue précédemment.

Selon un mode de réalisation particulier, les électrodes de lecture de pixels d'une même colonne et appartenant à deux lignes de pixels adjacentes associées à des portions électriquement conductrices différentes peuvent être reliées électriquement l'une à l'autre. Cette configuration permet de réduire le nombre de transistors de sélection et le nombre de lignes de sélection nécessaires pour réaliser la lecture des pixels du capteur.

En variante, il est toutefois possible de lire successivement deux lignes de pixels associées à une même portion électriquement conductrice réalisant le chauffage de ces deux lignes de pixels. Dans ce cas, un temps d'attente est respecté entre les lectures de ces deux lignes de pixels.

Selon une deuxième réalisation, il est possible que le capteur de motif thermique soit tel que :

- chaque pixel comprend en outre au moins un transistor de sélection relié à l'électrode de lecture dudit pixel,
- les grilles des transistors de sélection de pixels appartenant à des lignes de pixels adjacentes aptes à être chauffées simultanément par une même portion électriquement conductrice sont reliées à une seule ligne de sélection commune desdites lignes de pixels,
- pour chaque colonne de pixels, les transistors de sélection dont les grilles sont reliées à une même ligne de sélection sont reliés à des colonnes de lecture différentes chacune reliée à un circuit de lecture différent.

Par rapport à la première réalisation, le capteur selon cette deuxième réalisation comporte un plus grand nombre de colonnes de lecture ainsi qu'un plus grand nombre de circuits de lecture. Du fait que les lignes de pixels chauffées par une même portion électriquement conductrice peuvent être lues simultanément, la lecture des pixels est simplifiée, et il devient inutile de respecter un temps d'attente entre deux lectures successives de deux lignes de pixels associées à une même portion électriquement conductrices réalisant le chauffage de ces deux lignes de pixels.

Dans ce cas, le capteur de motif thermique peut comporter en outre un circuit de commande apte à mettre en oeuvre, pour une lecture simultanée de lignes de pixels adjacentes aptes à être chauffées simultanément par une même portion électriquement conductrice, au moins les étapes suivantes :

- mise à l'état passant des transistors de sélection des pixels desdites lignes de pixels ;
- application d'une tension de chauffage aux extrémités de la portion électriquement conductrice associée auxdites lignes de pixels ;
- réinitialisation des circuits de lecture ;
- attente d'un temps d'intégration correspondant à la mesure du motif thermique par les pixels desdites lignes de pixels ;
- lecture de la quantité de charges électriques reçues par les circuits de lecture ;
- mise à l'état bloqué des transistors de sélection des pixels desdites lignes de pixels.

L'étape de lecture de la quantité de charges électriques reçues par les circuits de lecture peut être suivie d'une étape d'arrêt de l'application de la tension de chauffage aux extrémités de la portion électriquement conductrice associée auxdites lignes de pixels.

Lors de la lecture d'une ligne de pixels, le circuit de commande peut être apte à appliquer au moins une deuxième tension de chauffage non nulle aux extrémités d'au moins une portion électriquement conductrice adjacente à la portion électriquement conductrice associée à la ligne de pixels lue. Ainsi, la chaleur générée par la portion électriquement conductrice adjacente à la portion électriquement conductrice associée à la ligne de pixels lue contribue au chauffage de la ligne de pixels lue. Le phénomène de diathermie est donc ici utilisé judicieusement pour injecter plus de chaleur dans la ligne de pixels lue et obtenir ainsi des signaux de lecture délivrés par les pixels lus qui soient plus important.

Dans ce cas, le chauffage réalisé par la ou les autres portions électriquement conductrices se trouvant à côté de la ligne de pixels lue peut être mis en oeuvre tel qu'une puissance de chauffage dissipée par cette ou ces autres portions électriquement conductrices soit inférieure à celle dissipée par la portion électriquement conductrice associée à la ligne de pixels lue. Dans ce cas, la chaleur est principalement apportée par la portion électriquement conductrice associée à la ligne de pixels lue et non par le chauffage latéral réalisé par la ou les autres portions électriquement conductrices. Cette maîtrise de la chaleur apportée à la ligne de pixels lue limite les effets indésirables de diathermie.

Le capteur peut comporter en outre un substrat sur lequel sont disposées les capacités pyroélectriques des pixels, l'électrode inférieure de la capacité pyroélectrique de chaque pixel formant l'électrode de lecture du pixel et étant disposée entre le substrat et la portion de matériau pyroélectrique de la capacité pyroélectrique du pixel.

Dans ce cas, les portions électriquement conductrices peuvent former les électrodes supérieures des capacités pyroélectriques des pixels, c'est-à-dire les électrodes les plus proches de la surface du capteur sur laquelle se trouve l'élément dont le motif thermique est mesuré.

Le capteur de motif thermique peut comporter en outre une couche diélectrique recouvrant l'électrode supérieure de chaque pixel de la matrice et une première couche électriquement conductrice disposée sur ladite couche diélectrique et formant un blindage électromagnétique du capteur.

En variante, les électrodes supérieures des capacités pyroélectriques des pixels peuvent être formée par une deuxième couche électriquement conductrice commune à tous les pixels de la matrice, apte à être reliée électriquement à un potentiel électrique de référence et disposée entre les portions électriquement conductrices et les électrodes de lecture. Cette variante est avantageuse car elle permet d'avoir une disposition des portions électriquement conductrices formant les éléments chauffants au plus près de l'élément présent sur le capteur et dont le motif thermique est destiné à être détecté.

Les électrodes de lecture des pixels peuvent être formées par des éléments de matériau électriquement conducteur distincts et isolés électriquement les uns des autres.

De manière avantageuse, le capteur de motif thermique peut être un capteur d'empreinte digitale thermique actif réalisé sur un substrat flexible avec des transistors de type TFT à base d'IGZO. Les électrodes inférieures peuvent être réalisées au-dessus des transistors, durant les étapes de lithographie formant les transistors du capteur, ce qui permet de réaliser ces électrodes inférieures avec une résolution importante. Le matériau pyroélectrique est déposé sur les électrodes inférieures, et les électrodes supérieures, formées avantageusement par les portions électriquement conductrices correspondant aux éléments chauffants des pixels, sont avantageusement réalisées sur le matériau pyroélectrique par la mise en oeuvre de techniques d'impression à bas coûts.

Enfin, l'invention concerne également un procédé de réalisation d'un capteur de motif thermique tel que décrit précédemment, dans lequel les portions électriquement conductrices sont réalisées par impression.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente une vue en coupe d'une capacité pyroélectrique d'un pixel d'un capteur de motif thermique, objet de la présente invention ;
- les figures 2 à 5 représentent des vues de dessus d'une partie de capteur de motif thermique selon différents modes de réalisation de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

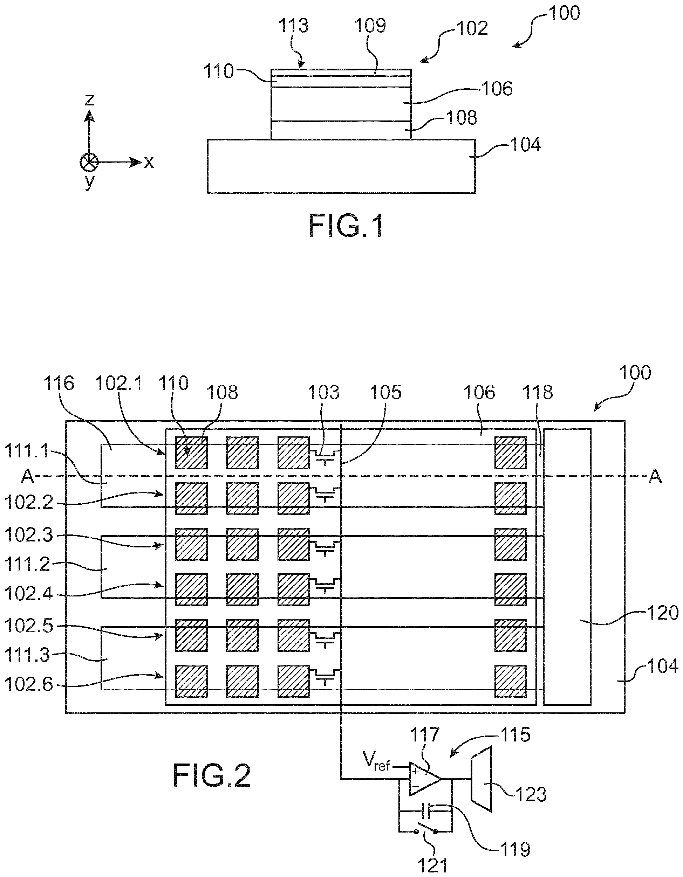

On se réfère tout d'abord à la figure 1 qui représente une vue en coupe d'une capacité pyroélectrique d'un pixel 102, qui forme l'élément de mesure thermosensible du pixel 102, d'un capteur 100 de motif thermique.

Le capteur 100 comporte un substrat 104 correspondant par exemple à un substrat de verre ou un substrat de semi-conducteur (par exemple du silicium). Un substrat 104 en verre peut être utilisé lorsque le capteur 100 est réalisé avec des transistors TFT, tandis qu'un substrat 104 en semi-conducteur, par exemple en silicium, peut être utilisé lorsque le capteur 100 comporte des transistors réalisés en technologie MOS. Le substrat 104 peut également être un substrat souple, par exemple à base de polyimide ou de PEN (polyéthylène naphtalate) ou de PET (polyéthylène téréphtalate), sur lequel les éléments électroniques du capteur 100, tels que des transistors TFT, sont réalisés par technologie électronique imprimée (par exemples via une réalisation avec des têtes d'écriture de type jet d'encre) ou par lithographie.

Les transistors réalisés sur le substrat 104 et sur lesquels les pixels 102 sont réalisés ne sont pas représentés sur la figure 1.

Les pixels 102 du capteur 100 sont réalisés sur le substrat 104 en formant une matrice de plusieurs lignes et plusieurs colonnes de pixels 102. Le pas des pixels 102 (correspondant à l'espacement entre les centres de deux pixels adjacents), dans le plan (X,Y) (c'est-à-dire le plan du substrat 104), est par exemple compris entre environ 25 $\mu$m et 100 $\mu$m. Dans le cas d'un capteur 100 de résolution égale à 500 dpi, le pas des pixels 102 est égal à 50,8 $\mu$m.

Chacun des pixels 102 du capteur 100 comporte des moyens de mesure, ou de détection, thermosensible formés par une capacité pyroélectrique. Chaque capacité pyroélectrique comporte une portion 106 de matériau pyroélectrique disposée entre une électrode inférieure 108 et une électrode supérieure 110. Le matériau pyroélectrique de la portion 106 est avantageusement du P(VDF-TrFE) ou du PVDF. En variante, le matériau pyroélectrique de la portion 106 peut être de l'AIN ou du PZT, ou tout autre matériau pyroélectrique adapté pour former une capacité pyroélectrique. L'épaisseur de la portion 106 est par exemple comprise entre environ 500 nm et 10 μm.

Les électrodes 108, 110 comportent chacune au moins un matériau électriquement conducteur, par exemple un matériau métallique tel que du titane d'épaisseur égale à environ 0,2 μm, et/ou du molybdène et/ou de l'aluminium et/ou un oxyde conducteur tel que de l'ITO (oxyde d'indium et d'étain) et/ou un polymère conducteur d'épaisseur par exemple égale à plusieurs microns, par exemple environ 4 μm. L'une des électrodes 108, 110, avantageusement l'électrode supérieure 110, ou chacune des deux électrodes 108, 110, peut être formée par un empilement de plusieurs matériaux électriquement conducteurs, par exemple un empilement Ti/TiN/AlCu. L'épaisseur de chacune des électrodes 108, 110 est par exemple comprise entre environ 0,1 μm et 1 μm. L'épaisseur de chacune des électrodes 108, 110 peut être plus importante, allant par exemple jusqu'à environ 5 μm, notamment lorsque ces électrodes sont réalisées par impression en utilisant des matériaux tels que l'argent, le cuivre, le carbone ou encore le PEDOT (poly(3,4-éthylènedioxythiophène)

Une couche de protection 109, correspondant par exemple à une couche de nitrure d'aluminium ou de tout autre matériau adapté à la réalisation de cette couche, recouvre l'électrode supérieure 110. L'épaisseur de la couche de protection 109 peut être comprise entre quelques microns et environ 100 μm, ou bien plus importante (par exemple de l'ordre de 300 μm ou plus). Une face supérieure 113 de la couche de protection 109 correspond à la surface sur laquelle se trouve le motif thermique destiné à être détecté, par exemple un doigt dont l'empreinte est destinée à être détectée.

Pour que le PVDF de la portion 106 acquière ses propriétés pyroélectriques (et aussi piézoélectriques), ce matériau est soumis, une fois pour toute la durée de vie de la capacité pyroélectrique, à un champ électrique d'environ 100 volts par micron d'épaisseur de PVDF. Les molécules à l'intérieur du PVDF s'orientent, et restent orientées ainsi, même lorsque le PVDF n'est plus soumis à ce champ électrique. Le PVDF peut être ainsi polarisé en appliquant une tension de polarisation initiale aux bornes des électrodes 108, 110.

Après cette polarisation initiale, lorsque la portion 106 est soumise à une variation de température ΔT, cette variation de température ΔT provoque l'apparition d'un champ électrique supplémentaire générant des charges ΔQ entre les électrodes 108, 110 telles que :

$$\Delta Q = S.\gamma.\Delta T$$

Le paramètre S correspond à la surface de la portion 106 en regard de chacune des électrodes 108, 110. Le paramètre γ correspond au coefficient pyroélectrique du matériau pyroélectrique de la portion 106. Par exemple, le coefficient pyroélectrique γ du PVFD-TrFE est égal à environ 32 μC/m²/K.

La portion 106 et les électrodes 108, 110 formant une capacité de valeur C à laquelle s'ajoutent des capacités parasites Cp, les charges ΔQ générées induisent une différence de potentiels électriques ΔV entre les électrodes 108, 110 telle que :

$$\left(C + C_p\right)\Delta V = \Delta Q = S.\gamma.\Delta T$$

En plus des charges générées par la capacité de valeur C, d'autres charges parasites peuvent être générées également via les capacités parasites Cp présentes, par exemple celles liées à la grille du transistor de lecture dans le cas d'un circuit de lecture en tension.

Lorsque le potentiel sur l'électrode de lecture (formée par l'une des électrodes 108,110) est fixe (lecture dite « en courant »), les charges générées s'écoulent vers le circuit de lecture en formant un courant intégré en sortie, avec dans ce cas :

$$\frac{\Delta Q}{\zeta} = \frac{S.\gamma.\Delta T}{\zeta}.$$

avec ζ correspondant au temps d'intégration pendant lequel la mesure est réalisée par le pixel. Une telle lecture en courant a pour avantage d'être insensible, au premier ordre, à la valeur des capacités, en particulier des capacités parasites.

Le signe de la tension électrique ΔV obtenue entre les électrodes 108, 110, ou le sens du courant dans le cas d'une lecture en courant, dépend du sens du champ électrique avec lequel le PVDF de la portion 106 a été initialement polarisé. Dans le cas de certains autres matériaux pyroélectriques tels que le nitrure d'aluminium, ce sens de polarisation initiale dépend de la manière avec laquelle le matériau pyroélectrique a été déposé, de son ordre et de son orientation cristallographique. En outre, la tension électrique ΔV obtenue, ou le sens du courant, peut être positive ou négative suivant que la variation de température subie par la capacité pyroélectrique soit positive ou négative.

Le capteur 100 comporte également des éléments chauffants dissipant une certaine quantité de chaleur dans les pixels 102, et plus particulièrement dans la portion 106 de matériau pyroélectrique, lors de la lecture des pixels 102. Dans l'exemple de réalisation décrit ici, ces éléments chauffants sont formés directement par l'une des électrodes 108,110 de chacune des capacités pyroélectriques. Sur l'exemple de la figure 1, l'élément chauffant de la capacité pyroélectrique du pixel 102 est formé par l'électrode supérieure 110. L'autre électrode de la capacité pyroélectrique, ici l'électrode inférieure 108, sert d'électrode de lecture du pixel 102.

Le chauffage de la portion 106 de matériau pyroélectrique est obtenu en faisant circuler un courant dans l'électrode destinée à former l'élément chauffant. Or, cette électrode sert également à la polarisation de la capacité pyroélectrique. Ainsi, la résistance de chauffage de chacun des pixels 102 sert donc également à la polarisation d'une électrode de la capacité pyroélectrique formée par la portion 106 et les électrodes 108, 110 de chacun des pixels 102 lors de la mesure réalisée par ces pixels 102 (la polarisation appliquée lors d'une mesure est différente de la polarisation initiale du PVDF précédemment décrite).

L'utilisation de l'une des électrodes 108, 110 des pixels 102 pour former les éléments chauffants est possible du fait que la valeur du potentiel électrique appliqué sur cette électrode lors d'une lecture du motif thermique est constante.

La figure 2 représente une vue de dessus de plusieurs pixels 102 du capteur 100 selon un premier mode de réalisation.

Les électrodes inférieures 108, qui correspondent aux électrodes de lecture des pixels sur lesquelles les charges générées par les capacités pyroélectriques seront récupérées pour être lues, sont formées par des éléments de matériau électriquement conducteur distincts et isolés électriquement les uns des autres pour chaque pixel 102. Ces éléments conducteurs ont chacun une section rectangulaire dans le plan du substrat 104 (plan (X,Y)), et sont disposés les uns à côté des autres sous la forme d'une matrice afin de former la matrice de pixels 102.

Le matériau pyroélectrique est réalisé sous la forme d'une seule portion 106, ou une seule couche 106, recouvrant toutes les électrodes inférieures 108.

Les électrodes supérieures 110 des pixels sont formées par plusieurs portions électriquement conductrices 111, référencées 111.1 à 111.3 sur la figure 2, formant chacune les électrodes supérieures 110 des pixels 102 appartenant à au moins deux lignes de pixels adjacentes (deux lignes de pixels adjacentes sur l'exemple de la figure 2). Chacune des portions 111 comporte une première extrémité 116 sur laquelle est appliqué un potentiel de chauffage, et une deuxième extrémité 118 reliée à une autre portion conductrice 120 commune à toutes les portions 111 et reliée à la masse. Les potentiels électriques appliqués sur les premières extrémités 116 des portions 111 sont similaires d'une portion 111 à l'autre.

Chacune des portions 111 est associée à au moins deux lignes de pixels aptes à être chauffées par la portion 111 qui lui est associée. Sur l'exemple de la figure 2, la portion 111.1 est associée aux lignes de pixels 102.1 et 102.2, la portion 111.2 est associée aux lignes de pixels 102.3 et 102.4, et la portion 111.3 est associée aux lignes de pixels 102.5 et 102.6.

Ainsi, dans ce premier mode de réalisation, chacune des portions 111.i forme un élément chauffant apte à chauffer les lignes de pixels 102.(2i) et 102.(2i-1), avec i nombre entier compris entre 1 et n/2 (pour un capteur 100 comprenant n lignes de pixels). Chacune des portions 111.i forme également les électrodes supérieures 110 de ces lignes de pixels 102.(2i) et 102.(2i-1).

Un circuit de commande (non représenté sur la figure 2) apte à commander l'allumage et l'extinction des éléments chauffants du capteur 100, c'est-à-dire à commander la circulation d'un courant de chauffage dans les portions 111, comporte par exemple une liaison électrique appliquant une tension existante dans le capteur 100 sur l'extrémité 116 de chacune des portions 111. Par exemple, si l'extrémité 118 d'une portion 111 est reliée à la masse et qu'un potentiel de chauffage $V_{chauffe}$ est appliqué sur l'extrémité 116 de cette portion 111, un courant s'écoule alors depuis l'extrémité 116 jusqu'à l'extrémité 118 de la portion 111, provoquant un échauffement par effet Joule dans la portion 111, et échauffant ainsi les portions de matériau pyroélectrique des pixels 102 de la ligne de pixels chauffés par cette portion 111. La valeur de la tension de chauffage est choisie en fonction de la puissance de chauffage désirée, cette puissance étant fonction notamment de l'épaisseur de la portion 106 destinée à être chauffée ainsi que de l'épaisseur de la couche de protection 109, du coefficient pyroélectrique du matériau de la portion 106, de la sensibilité du circuit de lecture, du niveau de bruit du circuit de lecture et du temps d'intégration. Dans un pixel 102, la puissance de chauffage est par exemple comprise entre environ 0,1 mW et 10 mW.

Avantageusement, les portions électriquement conductrices 111 qui servent de résistances de chauffage des pixels 102 forment également les électrodes supérieures 110 des pixels 102 qui sont disposées au-dessus du matériau pyroélectrique et non les électrodes inférieures 108 car cette disposition permet de relier à la masse du capteur 100 les portions conductrices des capacités pyroélectriques qui sont le plus proches de l'extérieur du capteur 100. Une telle disposition forme une protection vis-à-vis des décharges électrostatiques (ESD) car si une telle décharge intervient, il existe alors un chemin préférentiel pour écouler les charges électriques dues à cette décharge, ce qui limite les claquages de tension avec des éléments actifs fragiles du capteur 100 tels que les transistors.

Toutefois, il est possible que les éléments chauffants soient disposés sous la portion de matériau pyroélectrique 106 et forment les électrodes inférieures 108.

Dans l'exemple de réalisation représenté sur la figure 2, les portions 111 forment des bandes conductrices de largeur uniforme, sensiblement égale les unes par rapport aux autres et s'étendant chacune le long de deux lignes de pixels 102. La chaleur est ainsi diffusée de manière uniforme le long de chaque portion 111 qui diffuse de la chaleur dans les deux lignes de pixels 102 associées à cette portion 111.

Afin que le chauffage de chacune des deux lignes de pixels 102 associées à l'une des portions 111 soit similaire pour chacune des deux lignes de pixels 102, chaque portion 111 est ici symétrique par rapport à un axe parallèle aux deux lignes de pixels 102, cet axe se trouvant à une distance sensiblement égale de ces deux lignes de pixels 102. Sur l'exemple de la figure 2, la deuxième portion 111.1 est symétrique par rapport à l'axe AA passant entre les deux lignes de pixels 102.1 et 102.2 et à égale distance de ces deux lignes de pixels. Autrement dit, les surfaces des électrodes de lecture 108 des pixels 102 se trouvant en regard des portions électriquement conductrices 111 sont sensiblement égales les unes des autres. Ainsi, les pixels 102 ont tous une surface pyroélectrique équivalente, et le recouvrement des électrodes inférieures 108 de deux lignes de pixels adjacentes par la portion 111 formant les électrodes supérieures de ces pixels 102 est identique pour les deux lignes de pixels 102.

En variante, il est possible de réaliser le capteur 100 tel qu'il comporte une portion électriquement conductrice 111.0 supplémentaire telle que la portion électriquement conductrice 111.1 soit disposée entre la portion électriquement conductrice 111.2 et cette portion électriquement conductrice 111.0 supplémentaire (qui n'est disposée au-dessus d'aucun élément de mesure thermosensible de pixels). De même, le capteur 100 peut comporter une autre portion 111.((n/2)+1) supplémentaire telle que la portion électriquement conductrice 111.(n/2) (dans le cas d'un capteur comportant n lignes de pixels) soit disposée entre la portion électriquement conductrice 111.((n/2)-1) et cette autre portion électriquement conductrice 111.((n/2)+1) supplémentaire (qui n'est également disposée au-dessus d'aucun élément de mesure thermosensible de pixels). Cette variante permet à tous les pixels 102 du capteur 100 d'être disposés dans un environnement de chauffage similaire.

Lors d'une lecture d'une ligne de pixels, le potentiel électrique $V_{chauffe}$ appliqué sur l'une des électrodes de la capacité pyroélectrique est constant tout au long de la lecture d'un pixel. Par contre, du fait que la portion électriquement conductrice 111 sur laquelle est appliqué ce potentiel est commune à plusieurs pixels 102, la valeur du potentiel de chauffage appliqué sur l'une des électrodes des capacités pyroélectriques de chacun de ces pixels 102 est différente d'un pixel à l'autre. En considérant une ligne de pixels du capteur 100 représenté sur la figure 2, l'électrode supérieure 110 de la capacité pyroélectrique la plus proche de l'extrémité 116 est soumise à un potentiel sensiblement égal à $V_{chauffe}$. L'électrode supérieure 110 de la capacité pyroélectrique suivante est soumise à un potentiel électrique sensiblement égal à $V_{chauffe} - \delta V$. Les valeurs des potentiels électriques appliqués sur les électrodes supérieures 110 des capacités pyroélectriques diminuent proportionnellement à leur éloignement vis-à-vis de l'extrémité 116. Lorsque la portion conductrice 120 est reliée à la masse, l'électrode supérieure 110 de la dernière capacité pyroélectrique, correspondant à celle qui est voisine de la portion conductrice 120, est soumise à un potentiel électrique sensiblement égal à 0V, c'est-à-dire le potentiel électrique de la masse. Cette variation du potentiel électrique de chauffage appliqué d'un pixel à l'autre ne modifie pas le chauffage réalisé d'un pixel à l'autre du fait que l'écoulement du courant dans la portion électriquement conductrice 111 provoquant l'échauffement est le même dans toute la portion électriquement conductrice 111 et le même pour tous les pixels 102 car les résistances de chauffage de tous les pixels 102 sont identiques.

A la lecture des pixels de la ligne lue, les valeurs des potentiels sur chaque électrode sont différentes d'un pixel à l'autre. Par contre, pour une même variation de température, la différence de tensions, ou différence de nombre de charges, générée aux bornes des capacités pyroélectriques est identique. Or, ce sont les charges excédentaires générées par rapport à la tension de référence qui sont lues, qu'elles soient positives ou négatives.

Chacun des pixels 102 comporte au moins un transistor de sélection 103 (sur la figure 2, seuls les transistors de sélection 103 d'une seule colonne de pixels 102 sont représentés), et les transistors de sélection 103 des pixels 102 de chaque colonne de pixels 102 sont reliés à une colonne de lecture 105 (sur la figure 2, une seule colonne de lecture 105 associée à une colonne de pixels 102 est représentée) elle-même reliée à un circuit de lecture 115 (sur la figure 2, un seul circuit de lecture 115 associé à une colonne de pixels 102 est représenté). Lors de la lecture d'une ligne de pixels 102, les transistors de sélection 103 des pixels 102 de cette ligne sont mis à l'état passant, ce qui permet de relier les noeuds actifs des pixels 102 de cette ligne aux circuits de lecture 115 se trouvant en pied de chacune des colonnes de pixels 102. Les transistors de sélection 103 bloqués des pixels 102 appartenant aux autres lignes de pixels 102 empêchent le déplacement de charges depuis ces autres pixels 102 vers les circuits de lecture. D'autres transistors peuvent également être présents dans chaque pixel 102, notamment lorsque les pixels 102 sont lus en tension et qu'ils nécessitent la présence d'un transistor de réinitialisation et d'un transistor suiveur de tension, ou que le capteur 100 forme également un capteur optique dans lequel un transistor est présent dans chaque pixel 102 pour relier une photodiode de chaque pixel 102 à un circuit de lecture dédié.

Sur la figure 2, l'entrée du circuit de lecture 115 à laquelle est reliée la colonne de lecture 105 correspond à l'entrée inverseuse d'un amplificateur de lecture 117. Cet amplificateur de lecture 117 correspond ici à un amplificateur opérationnel. Un potentiel électrique de polarisation $V_{ref}$ est appliqué sur l'entrée non inverseuse de l'amplificateur 117. La sortie de l'amplificateur 117 est rebouclée sur son entrée inverseuse par l'intermédiaire d'une capacité 119. Un interrupteur 121, ou commutateur, est relié en parallèle à la capacité 119 et permet de court-circuiter la capacité 119 lors d'une réinitialisation du circuit de lecture 115. La sortie de l'amplificateur de lecture 117 est également reliée à l'entrée d'un convertisseur analogique/numérique 123. L'amplificateur de lecture 117, la capacité 119, l'interrupteur 121 et le convertisseur analogique/numérique 123 sont ici communs à tous les pixels 102 d'une même colonne. Le convertisseur analogique/numérique 123 peut être commun à toutes les colonnes de pixels 102 du capteur 100, moyennant l'ajout d'éléments électroniques de multiplexage entre les sorties des amplificateurs de lecture 117 associés aux différentes colonnes de pixels et le convertisseur analogique/numérique 123.

Les éléments électroniques formant les circuits de lecture 105 peuvent être réalisés sur un substrat différent de celui sur lequel les pixels 102 sont réalisés, ces substrats pouvant être assemblés ultérieurement l'un à l'autre. Ainsi, les éléments électroniques de ces circuits de lecture peuvent être réalisés avec une technologie de réalisation (par exemple CMOS) différente de celle servant à la réalisation des pixels 102 (par exemple par impression).

Dans le capteur 100 selon le premier mode de réalisation représenté sur la figure 2, les portions 111 ne sont pas disposées complètement en regard des électrodes inférieures 108. Pour chaque ligne de pixels 102, des parties des électrodes inférieures 108 de cette ligne de pixels 102 ne sont pas disposées en regard de la portion 111 associée à cette ligne de pixels 102.

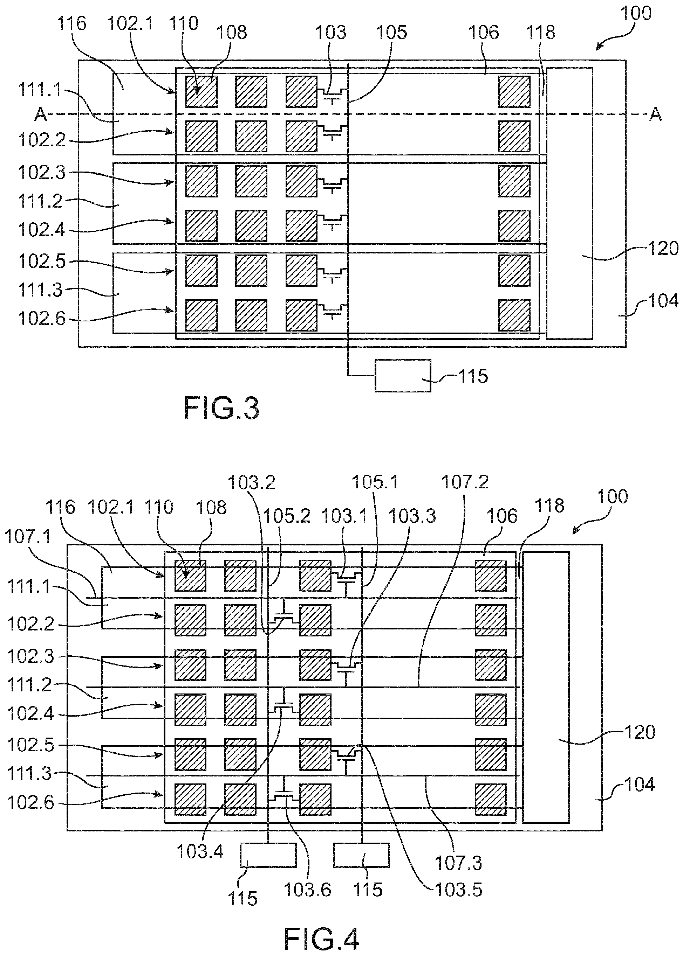

La figure 3 représente le capteur 100 selon une variante de ce premier mode de réalisation, dans lequel les portions électriquement conductrices 111 recouvrent complètement les électrodes inférieures. Ainsi, pour chaque ligne de pixels 102, toute la surface (dans le plan parallèle au substrat 104) des électrodes inférieures 108 de cette ligne de pixels 102 est disposée en regard de la deuxième portion 111 associée à cette ligne de pixels 102.

La lecture des pixels 102 du capteur 100 représenté sur la figure 2 ou sur la figure 3 peut être réalisée de différentes façons.

Par exemple, il est possible de lire séquentiellement les différentes lignes de pixels 102 en commençant par la première ligne de pixels 102.1 et en terminant par la dernière ligne de pixels 102.n. Dans ce cas, étant donné que chacune des portions électriquement conductrices 111 réalise un chauffage de deux lignes de pixels 102, il est nécessaire d'insérer, entre les lectures successives de deux lignes de pixels 102 chauffées par une même portion 111, un temps d'attente permettant à la ligne de pixels 102 chauffée mais non lue de refroidir avant de réaliser la lecture de celle-ci. Ce temps d'attente peut être de l'ordre de 3 à 5 fois le temps de chauffe réalisé pour la lecture d'une ligne de pixels 102.

De manière avantageuse, il est possible de réaliser tout d'abord la lecture des lignes de pixels impairs (102.1, 102.3, etc.), puis la lecture des lignes de pixels pairs (102.2, 102.4, etc.). Ainsi, il n'est pas nécessaire d'appliquer un temps d'attente entre deux lectures successives de lignes de pixels puisque lors de la lecture d'une des lignes de pixels, la ligne de pixels destinée à être lue immédiatement après n'est pas soumise au chauffage de la ligne de pixels lue.

Dans ce cas, la séquence de lecture réalisée peut être la suivante :

- sélection de la ligne 102.1 de pixels destinée à être lue, par exemple en mettant à l'état passant les transistors de sélection 103 des pixels de la ligne 102.1 ;
- allumage de l'élément chauffant associé aux lignes de pixels 102.1 et 102.2 via l'application d'une tension de chauffage sur la portion 111.1 ;
- réinitialisation des circuits de lecture 115 couplés à toutes les colonnes de pixels 105 (cette réinitialisation étant réalisée après le début du chauffage pour éviter une injection de bruit indésirable dans les circuits de lecture 115 au moment de l'allumage du chauffage) ;
- début d'intégration des pixels de la ligne 102.1;
- attente du temps d'intégration $\zeta$ par exemple égal à 1 ms ;
- lecture des signaux reçus par les circuits de lecture 115, qui correspondent aux variations de température mesurées par les pixels de la ligne 102.1 qui est lue ;
- extinction de l'élément chauffant ;
- désélection de la ligne 102.1.

La ligne de pixels 102.3 est ensuite lue en allumant le chauffage de cette ligne de pixels 102.3 via la portion 111.2, puis la ligne de pixels 102.5, etc. Après avoir réalisé la lecture des lignes de pixels impairs, les lignes de pixels paires sont lues en commençant par exemple par la ligne de pixels 102.2 à laquelle est associée la portion 111.1, puis la ligne de pixels 102.4, etc.

En variante, il est possible de commencer par la lecture des lignes de pixels paires, puis de lire les lignes de pixels impaires.

De manière générale, des ordres de lecture des lignes de pixels 102 différents de ceux précédemment décrits peuvent être envisagés. Il est toutefois préférable de ne pas lire de manière successive deux lignes de pixels 102 associées à un même élément chauffant 111 afin d'éviter d'avoir à respecter un temps d'attente pour refroidir la ligne de pixels chauffée mais non lue.

Afin d'améliorer le chauffage des lignes de pixels, le capteur 100 peut réaliser, lors de la lecture d'une des lignes de pixels 102, le chauffage de l'élément chauffant associé à la ligne de pixels lue ainsi que celui de l'élément chauffant se trouvant au-dessus ou au-dessous de l'élément chauffant associé à la ligne de pixels lue. Ainsi, sur l'exemple de la figure 2, lors de la lecture de la deuxième ligne de pixels 102.2, des tensions de chauffage non nulles peuvent être appliquées aux bornes de la deuxième portion 111.1 qui est associée à la deuxième ligne de pixels 102.2 ainsi qu'aux bornes de la deuxième portion 111.2 qui est associée aux deux lignes de pixels 102.3 et 102.4. Selon un autre exemple, lors de la lecture de la ligne de pixels 102.3, des tensions de chauffage peuvent être appliquées aux bornes des deuxièmes portions 111.1 et 111.2.

Ainsi, en réalisant un chauffage plus important des pixels lors de leur lecture, un signal de lecture plus important peut être obtenu. Dans ce cas, il est préférable de réaliser des lectures successives de lignes de pixels non adjacentes, par exemple dans cet ordre les lignes 102.1, 102.3, 102.5, etc., voire même 102.1, 102.5, 102.9, etc. pour éviter une attente d'un refroidissement des lignes de pixels chauffées.

Un nombre plus important d'éléments chauffants peuvent être allumés lors de la lecture d'une ligne de pixels du capteur 100. De plus, les courants de chauffage injectés dans les différents éléments chauffants ne sont pas nécessairement similaires.

En outre, les courants de chauffage injectés dans les différents éléments chauffants peuvent être adaptés en fonction de l'éventuel chauffage précédemment réalisé pour un ou plusieurs éléments chauffants lors d'une précédente lecture d'une ligne de pixels. Ainsi, pour un élément chauffant ayant servi à la lecture d'une précédente ligne de pixels, celui-ci est déjà chaud et nécessite donc une puissance de chauffage moindre que celle utilisée pour un élément chauffant non utilisé pour la lecture de la ligne de pixels précédente. Dans ce cas, l'intégration des pixels destinés à être lus est déjà commencée.

Un élément chauffant qui n'est pas associé à la ligne de pixels lue peut également être traversé par un courant de chauffage lors de la lecture de cette ligne de pixels, dans le but de réaliser un préchauffage de cet élément chauffage qui sera utilisé pour la lecture de la ligne de pixels suivante.

De manière générale, le temps d'intégration $\zeta$ est compris entre environ 30 μs et 1ms afin d'obtenir une variation de température comprise entre environ 0,5 K et 0,05 K.

Que la lecture soit réalisée en charges (ou en courant) ou en tension, l'allumage et l'extinction du chauffage ne sont de préférence pas réalisés pendant le temps d'intégration $\zeta$ et la lecture. En effet, l'allumage du chauffage fait varier de manière importante le potentiel d'une des électrodes des capacités pyroélectriques des pixels lus. Cette variation se retrouve donc sur l'autre électrode des capacités pyroélectriques des pixels lus. Cette variation de potentiel est, pour certains pixels, largement supérieure au signal destiné à être lu par ces pixels. Pour la même raison, il convient de limiter au maximum tous les parasites sur le potentiel $V_{chauffe}$ pendant le temps d'intégration, en particulier ceux liés aux appels de courant provenant du fonctionnement d'autres parties électroniques du capteur 100.

Dans le premier mode de réalisation précédemment décrit, chacune des portions 111 est apte à chauffer deux lignes de pixels 102 adjacentes. En variante, il est possible que chacune des portions 111 soit apte à chauffer plus de deux lignes de pixels 102 adjacentes. Ainsi, en considérant le capteur 100 représenté sur la figure 2 ou la figure 3, il est par exemple possible d'avoir une seule portion 111.1 formant les électrodes supérieures et les éléments chauffants des trois lignes de pixels 102.1- 102.3, ou encore des quatre lignes de pixels 102.1- 102.4, voire même un plus grand nombre de lignes de pixels. Pour les lignes de pixels se trouvant aux bords des portions 111, les éventuelles différences obtenues dans les signaux de lecture par rapport aux autres lignes de pixels peuvent être compensées par calcul ultérieurement.

La figure 4 représente le capteur 100 selon un deuxième mode de réalisation.

Dans ce deuxième mode de réalisation, les transistors de sélection 103 associés aux pixels d'une même colonne ne sont pas reliés à une seule colonne de lecture 105, mais à deux colonnes de lecture 105.1 et 105.2 telles qu'une partie des pixels 102 d'une colonne soient reliés à l'une des deux colonnes de lecture 105.1 et que les autres pixels 102 de cette colonne soient reliés à l'autre des deux colonnes de lecture 105.2. Sur l'exemple de la figure 4, les transistors de sélection des lignes de pixels impaires (transistors 103.1, 103.3 et 103.5) sont reliés à une première colonne de lecture 105.1 et les transistors de sélection des lignes de pixels paires (transistors 103.2, 103.4 et 103.6) sont reliés à une deuxième colonne de lecture 105.2. Ainsi, le capteur 100 selon ce deuxième mode de réalisation comporte un nombre de colonnes de lecture 105, et donc également un nombre de circuits de lecture 115, correspondant au double de celui du capteur 100 selon ce premier mode de réalisation.

Le capteur 100 selon ce deuxième mode de réalisation permet de réaliser une lecture simultanée de deux lignes de pixels 102 avantageusement chauffées par une même portion 111. De manière avantageuse, les grilles des transistors de sélection 103 des deux lignes de pixels destinées à être lues simultanément sont reliées à une même ligne de sélection 107 permettant de rendre passant les transistors de sélection 103 de ces deux lignes de pixels lors d'une lecture des deux lignes de pixels.

Dans ce cas, la séquence de lecture réalisée est la suivante :

- sélection des lignes 102.1 et 102.2 de pixels destinées à être lues en mettant à l'état passant les transistors de sélection 103 (les transistors 103.1 et 103.2 sur l'exemple de la figure 4) des pixels des lignes 102.1 et 102.2 ;
- allumage de l'élément chauffant associé aux lignes de pixels 102.1 et 102.2 via l'application d'une tension de chauffage sur la portion 111.1 ;

- réinitialisation des circuits de lecture 115 couplés à toutes les colonnes de pixels (cette réinitialisation étant réalisée après le début du chauffage pour éviter une injection de bruit indésirable dans les circuits de lecture au moment de l'allumage du chauffage) ;

- début d'intégration des pixels des lignes 102.1 et 102.2 ;

- attente du temps d'intégration $\zeta$ par exemple égal à 1 ms ;

- lecture des signaux reçus par les circuits de lecture 115, qui correspondent aux variations de température mesurées par les pixels des lignes 102.1 et 102.2 qui sont lues ;

- extinction de l'élément chauffant ;

- désélection des lignes 102.1 et 102.2.

Cette séquence de lecture est répétée pour chaque groupe suivant de deux lignes de pixels auxquelles l'une des portions 111 est associée.

Dans ce deuxième mode de réalisation, il est possible que les lignes de pixels paires et impaires aient des comportements différents suivant l'agencement des transistors au sein des pixels.

Dans les modes de réalisation précédemment décrits du capteur 100, les éléments chauffants sont formés à partir d'un même niveau électriquement conducteur que celui servant à former les électrodes supérieures des capacités pyroélectriques des pixels, les portions 111 formant à la fois les éléments chauffants et les électrodes supérieures des pixels 102.

En variante, il est possible que les éléments chauffants ne soient pas formés à partir du même niveau électriquement conducteur que celui servant à la réalisation des électrodes supérieures. Dans ce cas, les portions 111 et les électrodes supérieures 110 correspondent à des éléments distincts.

En variante, il est possible que les portions 111 formant les éléments chauffants des pixels soient recouvertes d'une couche diélectrique elle-même recouverte d'une couche électriquement conductrice qui est reliée électriquement à la masse. Cette couche électriquement conductrice peut être recouverte par la couche de protection 109. Cette couche électriquement conductrice, comprenant par exemple une encre électriquement conductrice, forme ainsi un blindage électromagnétique entre l'élément dont le motif thermique est destiné à être détecté, par exemple un doigt dans le cas d'un capteur 100 d'empreinte digitale, et les portions 111 formant les électrodes de polarisation de chaque pixel 102, évitant ainsi la récupération de bruit électromagnétique (par exemple du bruit à 50 Hz provenant du secteur) dans les mesures réalisées. Cette couche électriquement conductrice permet également de protéger le capteur 100 vis-à-vis des décharges électrostatiques (ESD).

De manière avantageuse, par rapport à la précédente variante de réalisation dans laquelle la couche électriquement conductrice formant la couche de blindage électromagnétique est disposée au-dessus des capacités pyroélectriques, cette couche de blindage électromagnétique peut être disposée directement au-dessus du matériau pyroélectrique. Cette couche de blindage électromagnétique est recouverte d'une couche diélectrique sur laquelle les portions 111 formant les éléments chauffants sont disposées. Dans cette configuration, les éléments chauffants sont bien disposés au plus près de l'élément dont le motif thermique est détecté par le capteur 100.

Sur la figure 4, la couche électriquement conductrice formant une telle couche de blindage est désignée par la référence 112.

Le motif thermique détecté par le capteur 100 correspond avantageusement à une empreinte digitale.

Bien que non représenté, le capteur 100 peut comporter en outre un circuit électronique de traitement apte à construire une image globale du motif thermique à partir des mesures réalisées au niveau de chacun des pixels 102. Ce circuit électronique de traitement peut également être apte à comparer cette image à plusieurs images stockées dans une base de données afin d'identifier si le motif thermique détecté correspond à l'un de ceux stockés dans la base de données. Le circuit électronique de traitement peut également être apte à afficher une image du motif thermique détecté.

Dans les modes de réalisation précédemment décrits, les portions 111 sont chauffées une par une, en appliquant un potentiel électrique approprié sur l'extrémité 116 de la portion 111 et en connectant l'extrémité 118 de cette portion 111 à la masse via la portion 120 à laquelle les extrémités 118 de toutes les deuxièmes portions 111 sont reliées. En variante, il est possible de ne pas relier l'extrémité 118 de la portion 111 chauffée à la masse, mais de relier les extrémités 116 des autres portions 111 à la masse. Par exemple en considérant le capteur 100 de la figure 2, lors de la lecture de la ligne de pixels 102.1 ou 102.2, un potentiel de chauffage est appliqué sur l'extrémité 116 de la portion 111.1 et les extrémités 116 des autres portions 111 (les portions 111.2 et 111.3 sur l'exemple de la figure 2) sont reliées à la masse.

Ainsi, le courant de chauffage traverse tout d'abord la portion 111.1, puis les autres portions 111 du capteur servent de à l'évacuation du courant à la masse. Les autres portions 111 sont donc également soumise à un chauffage, mais lorsque le capteur 100 comporte un grand nombre de lignes de pixels, par exemple une centaine, le courant se divise dans toutes ces autres portions 111 ce qui rend ce chauffage dans ces autres portions 111 négligeable par rapport à celui réalisé par la portion 111.1. Cela revient à l'ajout d'un signal moyen (le même pour toutes les lignes) en plus du signal de la ligne de pixels lus, ce qui équivaut à un simple décalage de la valeur du signal lu. Cette possibilité d'utiliser les portions conductrices associées aux lignes de pixels non lues pour évacuer le courant de chauffage peut s'appliquer à d'autres types de capteur, par exemple à un capteur dans lequel chaque deuxième portion 111 n'est associée qu'à une seule ligne de pixels.

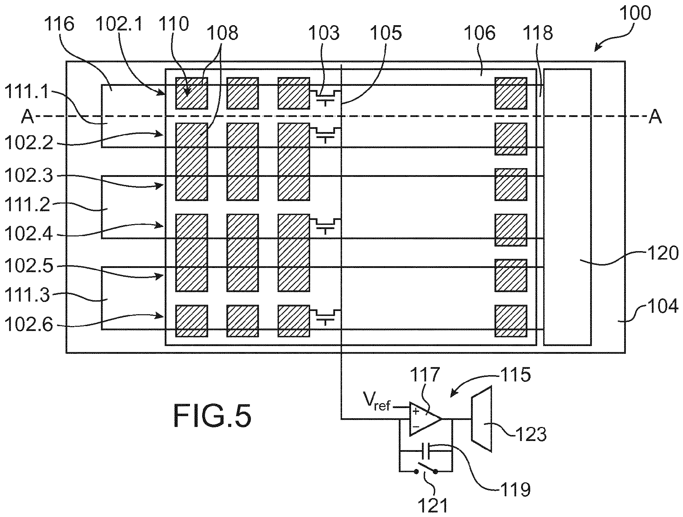

La figure 5 représente le capteur 100 selon un troisième mode de réalisation.

Par rapport aux précédents modes de réalisation, et pour au moins une partie des lignes de pixels 102 du capteur 100, chacune des électrodes de lecture 108 de ces lignes de pixels 102 n'est pas distincte pour chacun des pixels 102, mais est commune à deux pixels d'une même colonne qui sont chauffés par des portions 111 différentes. Ainsi, pour deux lignes de pixels adjacentes dont chacune est associée à une portion 111 différente, les électrodes de lecture de deux pixels se trouvant sur une même colonne sont reliées électriquement l'une à l'autre du fait qu'elles sont formées par une même portion de matériau électriquement conducteur. Sur l'exemple représenté sur la figure 5, les électrodes de lecture des pixels d'une même colonne et appartenant aux deux lignes de pixels 102.2 et 102.3, chacune associée à un élément chauffant différent (les éléments chauffants de la ligne de pixels 102.2 étant formés par la portion 111.1 et ceux de la ligne de pixels 102.3 étant formés par la portion 111.2) sont formées par une même portion de matériau électriquement conducteur. De même, les électrodes de lecture des pixels d'une même colonne et appartenant aux deux lignes de pixels 102.4 et 102.5, chacune associée à un élément chauffant différent (les éléments chauffants de la ligne de pixels 102.4 étant formés par la portion 111.2 et ceux de la ligne de pixels 102.5 étant formés par la portion 111.3) sont formées par une même portion de matériau électriquement conducteur.

Par rapport aux premier et deuxième modes de réalisation précédemment décrits, cette mise en commun des électrodes de lecture permet de réduire le nombre de transistors de sélection 103 nécessaires du fait qu'un seul transistor de sélection 103 est associé à chacune des portions formant les électrodes de lecture d'au moins deux pixels. En considérant deux lignes de pixels dont les électrodes de lecture sont formées, pour chaque colonne, par une seule portion électriquement conductrice, une seule ligne de transistors de sélection 103 est nécessaire pour réaliser la lecture de ces deux lignes de pixels. En outre, la réduction du nombre de transistors de sélection 103 implique, par rapport au premier mode de réalisation, également la réduction du nombre de lignes de sélection 107 qui sont reliées aux grilles des transistors de sélection 103.

Enfin, la lecture des pixels de ce capteur 100 selon le troisième mode de réalisation est mise en oeuvre de manière analogue à celle précédemment décrite pour le premier mode de réalisation.

## Revendications

**1.** Capteur (100) de motif thermique comportant une matrice de plusieurs lignes et colonnes de pixels (102), chaque pixel (102) comprenant

au moins une capacité pyroélectrique formée par au moins une portion de matériau pyroélectrique (106) disposée entre une électrode inférieure (108) et une électrode supérieure (110),

dans lequel une première des électrodes inférieure et supérieure forme une électrode de lecture (108) du pixel (102),
et comportant en outre une pluralité de portions électriquement conductrices (111) chacune

apte à chauffer par effet Joule, indépendamment des autres portions électriquement conductrices, les portions de matériau pyroélectrique (106) des capacités pyroélectriques des pixels (102) d'au moins deux lignes de pixels (102) adjacentes associées à la portion électriquement conductrice (111),
et disposée en regard d'au moins une partie de la surface des électrodes de lecture (108) de chacun des pixels (102) des lignes associées à la portion électriquement conductrice (111).

**2.** Capteur (100) de motif thermique selon la revendication 1, dans lequel chacune des portions électriquement conductrices (111) est disposée en regard de l'ensemble de la surface de l'électrode de lecture (108) de chacun des pixels (102) des lignes associées à la portion électriquement conductrice (111).

**3.** Capteur (100) de motif thermique selon la revendication 1, dans lequel chacune des portions électriquement conductrices (111) est disposée en regard d'une partie de la surface de l'électrode de lecture (108) de chacun des pixels (102) des lignes associées à la portion électriquement conductrice (111), les surface des électrodes de lecture (108) des pixels (102) se trouvant en regard des portions électriquement conductrices (111) étant sensiblement égales les unes des autres.

**4.** Capteur (100) de motif thermique selon l'une des revendications précédentes, dans lequel :

- chaque pixel (102) comprend en outre au moins un transistor de sélection (103) relié à l'électrode de lecture (108) dudit pixel (102),
- pour chaque ligne de pixels (102), les grilles des transistors de sélection (103) des pixels (102) de ladite ligne de pixels (102) sont reliées à une ligne de sélection (107) de ladite ligne de pixels (102),
- pour chaque colonne de pixels (102), les transistors de sélection (103) des pixels (102) de ladite colonne de pixels (102) sont reliés à une colonne de lecture (105) de ladite colonne de pixels (102) qui est reliée à un circuit de lecture (115) commun aux pixels (102) de ladite colonne de pixels (102).

5. Capteur (100) de motif thermique selon la revendication 4, comportant en outre un circuit de commande apte à mettre en oeuvre, pour la lecture d'une ligne de pixels (102), au moins les étapes suivantes :

- mise à l'état passant des transistors de sélection (103) des pixels (102) de ladite ligne ;
- application d'une tension de chauffage aux extrémités (116, 118) de la portion électriquement conductrice (111) associée à ladite ligne de pixels (102) ;
- réinitialisation des circuits de lecture (115) ;
- attente d'un temps d'intégration correspondant à la mesure du motif thermique par les pixels (102) de ladite ligne ;
- lecture de la quantité de charges électriques reçues par les circuits de lecture (115) ;
- mise à l'état bloqué des transistors de sélection (103) des pixels (102) de ladite ligne.

6. Capteur (100) de motif thermique selon la revendication 5, dans lequel le circuit de commande est apte à commander la lecture successive de plusieurs lignes de pixels (102) telle que deux lignes de pixels (102) lues successivement sont associées à des portions électriquement conductrices (111) différentes.

7. Capteur (100) de motif thermique selon l'une des revendications précédentes, dans lequel les électrodes de lecture (108) de pixels (102) d'une même colonne et appartenant à deux lignes de pixels (102) adjacentes associées à des portions électriquement conductrices (111) différentes sont reliées électriquement l'une à l'autre.

8. Capteur (100) de motif thermique selon l'une des revendications 1 à 3, dans lequel :

- chaque pixel (102) comprend en outre au moins un transistor de sélection (103) relié à l'électrode de lecture (108) dudit pixel (102),
- les grilles des transistors de sélection (103) de pixels (102) appartenant à des lignes de pixels (102) adjacentes aptes à être chauffées simultanément par une même portion électriquement conductrice (111) sont reliées à une seule ligne de sélection (107) commune desdites lignes de pixels (102),
- pour chaque colonne de pixels (102), les transistors de sélection (103) dont les grilles sont reliées à une même ligne de sélection (107) sont reliés à des colonnes de lecture (105) différentes chacune reliée à un circuit de lecture (115) différent.

9. Capteur (100) de motif thermique selon la revendication 8, comportant en outre un circuit de commande apte à mettre en oeuvre, pour une lecture simultanée de lignes de pixels (102) adjacentes aptes à être chauffées simultanément par une même portion électriquement conductrice (111), au moins les étapes suivantes :

- mise à l'état passant des transistors de sélection (103) des pixels (102) desdites lignes de pixels (102) ;
- application d'une tension de chauffage aux extrémités (116, 118) de la portion électriquement conductrice (111) associée auxdites lignes de pixels (102) ;
- réinitialisation des circuits de lecture (115) ;
- attente d'un temps d'intégration correspondant à la mesure du motif thermique par les pixels (102) desdites lignes de pixels (102) ;
- lecture de la quantité de charges électriques reçues par les circuits de lecture (115) ;
- mise à l'état bloqué des transistors de sélection des pixels (102) desdites lignes de pixels (102) ;
- arrêt de l'application de la tension de chauffage aux extrémités (116, 118) de la portion électriquement conductrice (111) associée auxdites lignes de pixels (102).

10. Capteur (100) de motif thermique selon l'une des revendications 5, 6 et 9, dans lequel, lors de la lecture d'une ligne de pixels (102), le circuit de commande est apte à appliquer au moins une deuxième tension de chauffage non nulle aux extrémités (116, 118) d'au moins une portion électriquement conductrice (111) adjacente à la portion électriquement conductrice (111) associée à la ligne de pixels (102) lue.

11. Capteur (100) de motif thermique selon l'une des revendications précédentes, comportant en outre un substrat (104) sur lequel sont disposées les capacités pyroélectriques des pixels (102), l'électrode inférieure (108) de la capacité pyroélectrique de chaque pixel (102) formant l'électrode de lecture du pixel et étant disposée entre le substrat (104) et la portion de matériau pyroélectrique (106) de la capacité pyroélectrique du pixel (102).

12. Capteur (100) de motif thermique selon la revendication 11, dans lequel les portions électriquement conductrices (111) forment les électrodes supérieures (110) des capacités pyroélectriques des pixels (102).

13. Capteur (100) de motif thermique selon l'une des revendications précédentes, comportant en outre une couche diélectrique recouvrant l'électrode supérieure (110) de chaque pixel (102) de la matrice et une première couche électriquement conductrice disposée sur ladite couche diélectrique et formant un blindage électromagnétique du capteur (100).

**14.** Capteur (100) de motif thermique selon la revendication 11, dans lequel les électrodes supérieures (110) des capacités pyroélectriques des pixels (102) sont formée par une deuxième couche électriquement conductrice commune à tous les pixels (102) de la matrice, apte à être reliée électriquement à un potentiel électrique de référence et disposée entre les portions électriquement conductrices (111) et les électrodes de lecture (110).

**15.** Procédé de réalisation d'un capteur (100) de motif thermique selon l'une des revendications précédentes, dans lequel les portions électriquement conductrices (111) sont réalisées par impression.

FIG.1

FIG.2

FIG.3

FIG.4

FIG.5

**EP 3 276 533 A2**

## RÉFÉRENCES CITÉES DANS LA DESCRIPTION

**Documents brevets cités dans la description**

- US 4394773 A
- US 4429413 A
- US 6289114 B
- US 6091837 A
- EP 2385486 A1